**Europäisches Patentamt**

**European Patent Office**

**Office européen des brevets**

(19)

(11) Veröffentlichungsnummer: **0 055 724**
**B1**

(12) EUROPÄISCHE PATENTSCHRIFT

(45) Veröffentlichungstag der Patentschrift:
03.10.84

(51) Int. Cl.³: **H 03 F 3/30**

(21) Anmeldenummer: **81901815.1**

(22) Anmeldetag: **27.06.81**

(86) Internationale Anmeldenummer:
**PCT/EP 81/00087**

(87) Internationale Veröffentlichungsnummer:
**WO 82/00227** (21.01.82 Gazette 82/3)

(54) **SCHALTUNGSANORDNUNG ZUR ABLEITUNG VON SIGNAL UND GEGENTAKTSIGNAL AUS EINEM EINSEITIGEN EINGANGSSIGNAL.**

(30) Priorität: **03.07.80 DE 3025162**

(43) Veröffentlichungstag der Anmeldung:
**14.07.82 Patentblatt 82/28**

(45) Bekanntmachung des Hinweises auf die Patenterteilung:
**03.10.84 Patentblatt 84/40**

(84) Benannte Vertragsstaaten:
**FR GB**

(56) Entgegenhaltungen:
**DE - A - 2 544 000**
**US - A - 3 855 541**
**US - A - 3 886 466**
**US - A - 4 049 977**

**R.C.A. Technical Notes, no. 1167, 15 October 1976, (Princeton, US), M.B. Knight "Voltage-to-current converters", see pages 1-5**

(73) Patentinhaber: **Felten & Guilleaume Fernmeldeanlagen GmbH, Thurn-und-Taxis-Strasse 10 Postfach 4943, D-8500 Nürnberg 10 (DE)**

(72) Erfinder: **SCHEMMEL, Hans-Robert, Friedrichstrasse 49/I, D-8500 Nürnberg (DE)**
Erfinder: **REICHELT, Ingo, Wilhelm-Albrecht-Strasse 10, D-8500 Nürnberg (DE)**

(74) Vertreter: **Peuckert, Hermann, Philips Patentverwaltung GmbH Billstrasse 80 Postfach 10 51 49, D-2000 Hamburg 28 (DE)**

## Beschreibung

Bei der Erfindung handelt es sich um eine Schaltungsanordnung zur Ableitung von Signal und Gegentaktsignal aus einem einseitigen Eingangssignal mit mindestens einer Stromspiegelschaltung, mit einem ersten und zweiten Transistor, deren Basen miteinander verbunden und an eine einstellbare Gleichspannungsquelle angeschlossen sind, deren Kollektoren oder Emitter über je einen ersten und zweiten Widerstand an eine Gleichspannungsquelle angeschlossen sind, deren nicht an die Gleichspannungsquelle angeschlossene Elektroden, Kollektoren oder Emitter, mit den Kollektoren oder Emittern eines dritten und vierten Transistors verbunden sind, wobei die Basen des dritten und vierten Transistors ebenfalls miteinander verbunden sind und an eine Elektrode, Kollektor oder Emitter, des dritten oder vierten Transistors angeschlossen sind und wobei das einseitige Eingangssignal in die Verbindung zwischen dem ersten und dritten Transistor oder in die Verbindung zwischen dem zweiten und vierten Transistor eingespeist wird.

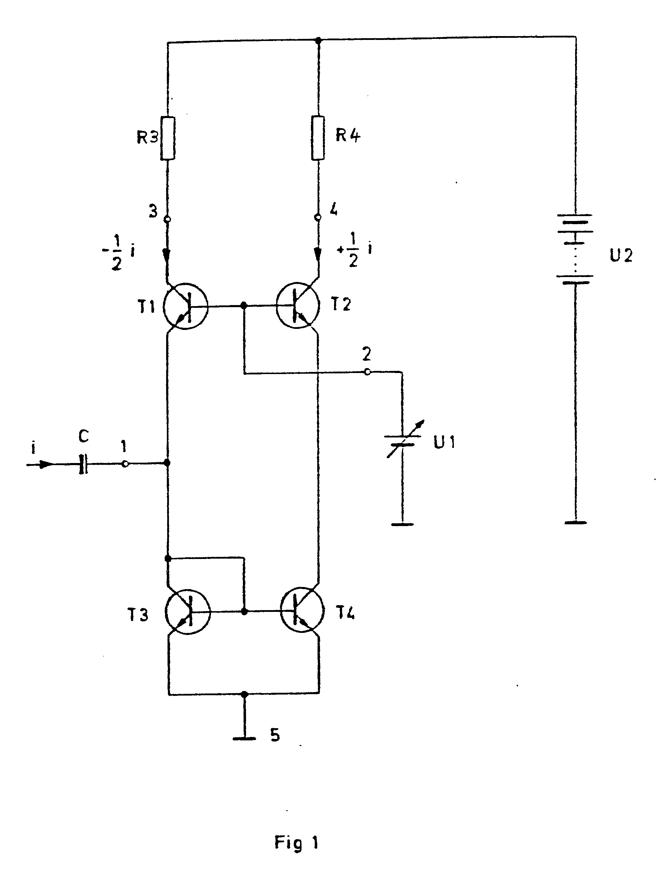

Aus der US-PS 4 049 977 ist eine derartige Schaltungsanordnung bekannt. Eine entsprechende Anordnung ist in Fig. 1 gezeigt. Der Kollektor eines Transistors T1 liegt über einen Widerstand R3 und der Kollektor eines Transistors T2 über einen Widerstand R4 an einer Gleichspannung U2. Der Emitter des Transistors T1 ist mit dem Kollektor eines Transistors T3 verbunden, dessen Emitter mit dem Emitter eines Transistors T4 verbunden ist. Die miteinander verbundenen Basen der Transistoren T3 und T4 sind an den Kollektor des Transistors T3 angeschlossen. Der Kollektor des Transistors T4 ist mit dem Emitter des Transistors T2 verbunden. Das einseitige wechselförmige Eingangssignal wird über die Anschlüsse 1 und 5 der Schaltung zugeführt. Die Einstellung des Ruhegleichstroms erfolgt durch Anlegen eines konstanten Potentials an die miteinander verbundenen Basen der Transistoren T1 und T2 mittels einer einstellbaren Spannungsquelle U1. Takt und Gegentaktsignal werden den Anschlüssen 3 und 4, den Kollektoren der Transistoren T1 und T2, entnommen. Die mit den Transistoren T3 und T4 gebildete Stromspiegelschaltung bewirkt, dass der Ruhegleichstrom annähernd symmetrisch auf die Kollektor-Emitter-Strecke der Transistorenpaare T1 und T3 sowie T2 und T4 verteilt wird.

Aufgabe der Erfindung ist es, eine Schaltungsanordnung der eingangs genannten Art anzugeben, die gegenüber der bekannten Schaltung aus der US-PS 4 049 977 verbesserte Gleichstromsymmetrieeigenschaften aufweist.

Die Erfindung löst die Aufgabe dadurch, dass in der Verbindung zwischen dem ersten und dem dritten Transistor ein dritter Widerstand liegt und dass in der Verbindung zwischen dem zweiten und dem vierten Transistor die Kollektor-Emitter-Strecke eines fünften Transistors liegt, dessen Basis an den Verbindungspunkt des dritten Widerstands und des dritten Transistors angeschlossen ist.

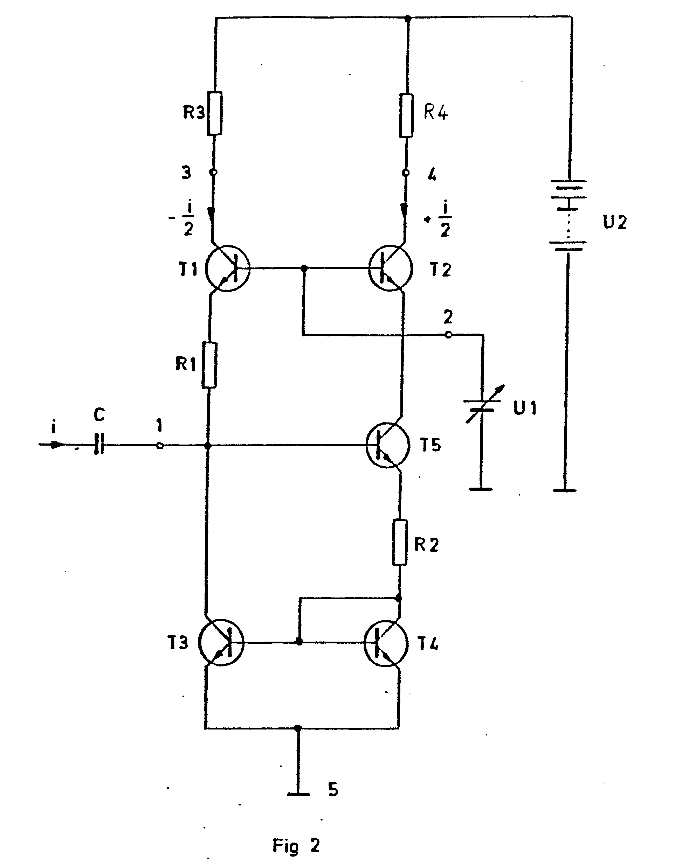

Es zeigen die Fig. 1 die bekannte Schaltungsanordnung, die Fig. 2, 3, 4 und 5 Ausführungsbeispiele der Erfindung.

Zum besseren Verständnis des Gleichstromverhaltens ist in der Fig. 2 die äussere Beschaltung zur Einstellung des Ruhegleichstroms mit eingezeichnet, bei den anderen Ausführungsbeispielen ist sie dagegen der Einfachheit halber weggelassen.

Fliesst in der Fig. 1 z.B. durch die Kollektor-Emitter-Strecke des Transistors T1 der Gleichstrom I, so wird dieser Gleichstrom so aufgeteilt, dass die Basisströme $2I_B$ für die Transistoren T3 und T4 abgezweigt werden, während in den Kollektor des Transistors T3 der Gleichstrom $I-2I_B$ fliesst. Durch den Stromspiegel wird dieser Strom $I-2I_B$, der in den Kollektor des Transistors T4 fliesst, in die Kollektor-Emitter-Strecke des Transistors T2 gespiegelt. Aus den Emittern der Transistoren T3 und T4 fliesst dann jeweils der Gleichstrom $I-I_B$.

Bei dem ersten Ausführungsbeispiel in der Fig. 2 sind die Kollektoren der Transistoren T1 und T2 über je einen Widerstand R3 und R4 mit einer Gleichspannungsquelle U2 verbunden. Die Basen der Transistoren T1 und T2 sind miteinander verbunden und an eine einstellbare Gleichspannungsquelle U1 angeschlossen.

Der Emitter des Transistors T1 ist über einen Widerstand R1 an den Kollektor eines Transistors T3 angeschlossen, dessen Emitter mit dem Emitter eines Transistors T4 verbunden ist. Der Kollektor des Transistors T4 ist an die miteinander verbundenen Basen der Transistoren T3, T4 angeschlossen. Der Kollektor des Transistors T4 ist über einen Widerstand R2 mit dem Emitter eines Transistors T5 verbunden, dessen Basis mit dem Kollektor des Transistors T3 und dessen Kollektor mit dem Emitter des Transistors T2 verbunden ist. Kollektor und Emitter des Transistors T3 bilden den Eingang 1, 5 für das einseitige Eingangssignal. Die Kollektoren der Transistoren T1 und T2 bilden die Anschlüsse 3 und 4 zur Entnahme von Signal und Gegentaktsignal, die miteinander verbundenen Basen derselben Transistoren bilden den Anschluss 2 für die Gleichstromeinstellung.

Die Potentialtrennung erfolgt durch eine Kapazität C, die vor den Anschluss 1 geschaltet ist. Wie sich leicht zeigen lässt, wird die Gleichstromsymmetrie durch den fünften Transistor T5 verbessert: Durch die Kollektor-Emitter-Strecke des Transistors T2 fliesst der Gleichstrom I zum Kollektor des Transistors T5. Der Emitterstrom des Transistors T5 beträgt dann $I+I_B$, fliesst durch den Widerstand R2 und teilt sich in den zweifachen Basistrom $2I_B$ für die Transistoren T3 und T4 sowie in den Kollektorstrom $I-I_B$ des Transistors T4 auf. Der Emitterstrom des Transistors T4 beträgt dann I. Der Emitterstrom des Transistors T3 beträgt ebenfalls I, während der Kollektorstrom dieses Transistors $I-I_B$ ist.

Dagegen ist der Strom durch die Kollektor-Emitter-Strecke des Transistors T1 und durch den Widerstand R1 I, weil vom Verbindungspunkt des Widerstands R1 mit dem Kollektor des Transistors T3 der Basistrom $I_B$ zur Basis des Transistors T5 fliesst.

Der Eingangswechselstrom i teilt sich am Anschluss 1 so auf, dass $+1/2i$ über den Widerstand R1 zum Anschluss 3 fliesst und $-1/2i$ in den Kollektor des Transistors T3 fliesst. Der als Emitterfolger geschaltete Transistor T5 wird vom Spannungsabfall an R1 gesteuert. Mit dem Widerstand R2 wird der Emitterstrom des Transistors T5 eingestellt. Der Eingangswiderstand der erfindungsgemässen Schaltung beträgt ungefähr R/2.

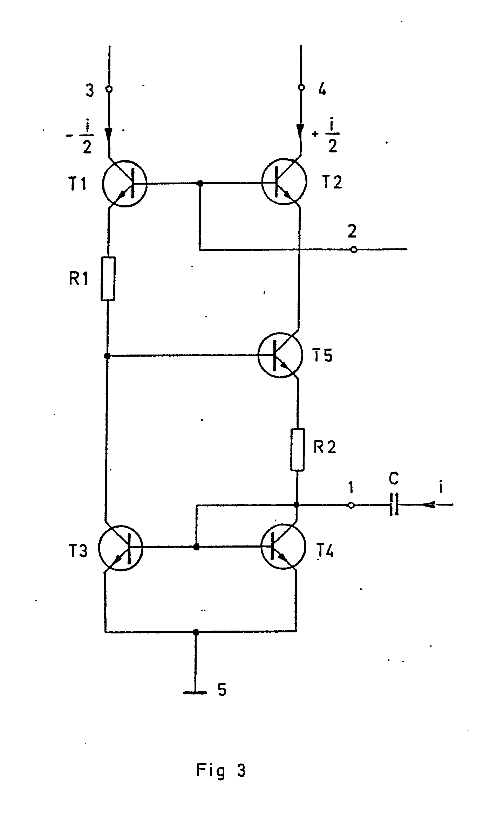

Ein zweites Ausführungsbeispiel, gezeigt in Fig. 3, unterscheidet sich vom ersten Beispiel schaltungsmässig nur dadurch, dass der Anschluss 1 für das einseitige Eingangssignal nicht am Kollektor des Transistors T3, sondern am Kollektor des Transistors T4 vorgesehen ist. Gegenüber dem ersten Ausführungsbeispiel hat das zweite Beispiel den Vorteil eines geringeren Eingangswiderstands mit einem Wert von etwa 1 : s. s ist die Steilheit des Transistors T4.

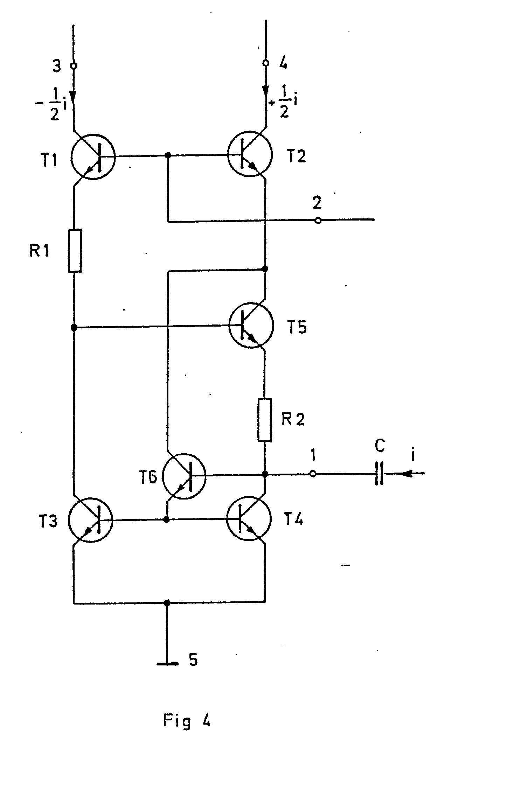

Ein drittes Ausführungsbeispiel ist in Fig. 4 dargestellt. Es unterscheidet sich vom zweiten dadurch, dass ein Transistor T6 vorgesehen ist, dessen Basis mit dem Kollektor des Transistors T4 verbunden ist, dessen Kollektor mit dem Kollektor des Transistors T5 verbunden ist und dessen Emitter an die miteinander verbundenen Basen der Transistoren T3 und T4 angeschlossen ist.

Verglichen mit dem zweiten Ausführungsbeispiel weist dieses Beispiel eine weiter verbesserte Gleichstromsymmetrie und einen geringeren Eingangswiderstand auf.

Der Eingangswiderstand beträgt ungefähr 1 : (B s), wobei B die Stromverstärkung des Transistors T6 und s die Steilheit des Transistors T4 ist.

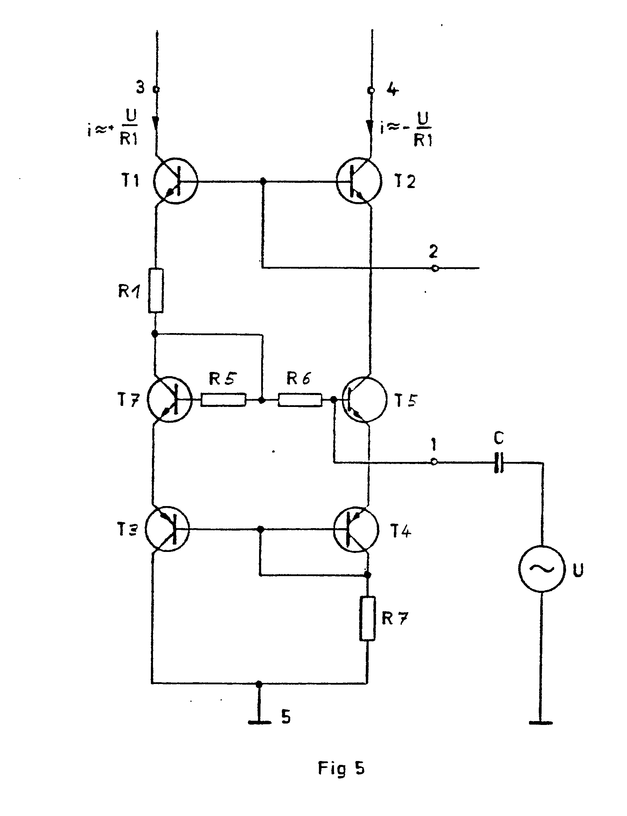

Ein viertes Ausführungsbeispiel, das in Fig. 5 gezeigt ist, enthält zwei Stromspiegelschaltungen mit Transistoren verschiedenen Leitfähigkeitstyps. Die Schaltung it wie folgt aufgebaut: Der Emitter des Transistors T1 ist über einen Widerstand R1 mit dem Kollektor eines Transistors T7 verbunden, dessen Emitter mit dem Emitter eines Transistors T3 verbunden ist. Der Kollektor des Transistors T3 ist über einen Widerstand R7 mit dem Kollektor eines Transistors T4 verbunden, dessen Kollektor an die miteinander verbundenen Basen der Transistoren T3, T4 angeschlossen ist. Der Emitter des Transistors T4 ist mit dem Emitter eines Transistors T5 verbunden, dessen Basis über eine Reihenschaltung aus zwei Widerständen R5, R6 mit der Basis des Transistors T7 verbunden ist. Der Kollektor des Transistors T7 ist an die Mittelanzapfung der Widerstandsreihenschaltung R5, R6 angeschlossen. Der Kollektor des Transistors T5 ist mit dem Emitter des Transistors T2 verbunden. Die Basis des Transistors T5 und der Kollektor des Transistors T3 bilden den Eingang 1,5 für das einseitige Eingangssignal. Signal und Gegentaktsignal sind an den Anschlüssen 3 und 4, den Kollektoren der Transistoren T1 und T2, zu entnehmen.

Die beiden Stromspiegelschaltungen, gebildet aus dem Transistorpaar T7, T5 sowie dem Transistorpaar T3, T4 sind in Reihe geschaltet. Dadurch wird der Eingangswiderstand nach dem Bootstrap-Prinzip erhöht.

Die Einstellung des Ruhegleichstroms erfolgt wie bei den anderen Ausführungsbeispielen durch Anlegen eines konstanten Potentials an die miteinander verbundenen Basen 2 der Transistoren T1, T2.

Im Gegensatz zu den bisherigen Ausführungsbeispielen, die alle stromgesteuert sind, wird die vierte Version von einer Spannung U gesteuert.

## Patentansprüche

1. Schaltungsanordnung zur Ableitung von Signal- und Gegentaktsignal aus einem einseitigen Eingangssignal mit mindestens einer Stromspiegelschaltung, mit einem ersten und zweiten Transistor (T1, T2), deren Basen miteinander verbunden und an eine einstellbare Gleichspannungsquelle (U1) angeschlossen sind, deren Kollektoren oder Emitter über je einen ersten und zweiten Widerstand (R3, R4) an eine Gleichspannungsquelle (U2) angeschlossen sind, deren nicht an die Gleichspannungsquelle (U2) angeschlossene Elektroden, Kollektoren oder Emitter, mit den Kollektoren oder Emittern eines dirtten und vierten Transistors (T3, T4) verbunden sind, wobei die Basen des dritten und vierten Transistors (T3, T4) ebenfalls miteinander verbunden sind und an eine Elektrode, Kollektor oder Emitter, des dritten oder vierten Transistors (T3, T4) angeschlossen sind und wobei das einseitige Eingangssignal in die Verbindung zwischen dem ersten und dritten Transistor (T1, T3) oder in die Verbindung zwischen dem zweiten und vierten Transistor (T2, T4) eingespeist wird, dadurch gekennzeichnet, dass in der Verbindung zwischen dem ersten und dem dritten Transistor (T1, T3) ein dritter Widerstand (R1) liegt und dass in der Verbindung zwischen dem zweiten und dem vierten Transistor (T2, T4) die Kollektor-Emitter-Strecke eines fünften Transistors (T5) liegt, dessen Basis an den Verbindungspunkt des dritten Widerstands (R1) und des dritten Transistors (T3) angeschlossen ist.

2. Schaltungsanordnung nach Anspruch 1, dadurch gekennzeichnet, dass ein vierter Widerstand (R2) in der Verbindung zwischen dem vierten und dem fünften Transistor (T4, T5) liegt und dass alle Transistoren (T1, T2, T3, T4, T5) vom gleichen Leitfähigkeitstyp sind.

3. Schaltungsanordnung nach Aspruch 2, dadurch gekennzeichnet, dass das einseitige Eingangssignal über eine Kapazität (C) der Basis des fünften Transistors (T5) zugeführt wird.

4. Schaltungsanordnung nach Anspruch 2, dadurch gekennzeichnet, dass das einseitige Eingangssignal über eine Kapazität (C) dem Verbindungspunkt des vierten Widerstands (R2) und des vierten Transistors (T4) zugeführt wird.

5. Schaltungsanordnung nach Anspruch 4, dadurch gekennzeichnet, dass der Verbindungspunkt des zweiten und fünften Transistors (T2, T5) über die Kollektor-Emitter-Strecke eines sechsten Transistors (T6) mit den Basen des dritten und vierten Transistors (T3, T4) verbunden ist, dass die Basis des sechsten Transistors (T6) mit dem Verbindungspunkt des vierten Widerstands (R2) und des vierten Transistors (T4) verbunden ist und dass alle Transistoren (T1, T2, T3, T4, T5, T6) vom gleichen Leitfähigkeitstyp sind.

6. Schaltungsanordnung nach Anspruch 1, dadurch gekennzeichnet, dass zwischen dem dritten Widerstand (R1) und dem dritten Transistor (T3) die Kollektor-Emitter-Strecke eines sechsten Transistors (T7) liegt, dessen Basis über eine Reihenschaltung aus einem vierten und fünften Widerstand (R5, R6) mit der Basis des fünften Transistors (T5) verbunden ist, dass der Verbindungspunkt des dritten Widerstands (R1) und des sechsten Transistors (T7) mit dem Verbindungspunkt des vierten und fünften Widerstands (R5, R6) verbunden ist, dass die nicht mit dem fünften und sechsten Transistor (T5, T7) verbundenen Eektroden des dritten und vierten Transistors (T3, T4), Kollektoren oder Emitter, über einen sechsten Widerstand (R7) miteinander verbunden sind, dass die Basen des dritten und vierten Transistors (T3, T4) an den Verbindungspunkt des vierten Transistors (T4) und des sechsten Widerstands (R7) angeschlossen sind, dass das einseitige Eingangssignal über eine Kapazität (C) der Basis des fünften Transistors (T5) zugeführt wird und dass der erste, zweite, fünfte und sechste Transistor (T1, T2, T5, T7) von einem Leitfähigkeitstyp sind, während der dritte und vierte Transistor (T3, T4) vom entgegengesetzten Leitfähigkeitstyp sind.


## Claims

1. A circuit arrangement for deriving a signal and a symmetrical signal from an asymmetrical signal, which arrangement comprises at least one current-mirror circuit comprising a first and a second transistor (T1, T2), whose bases are interconnected and are connected to a variable direct-voltage source (U1), whose collectors or emitters are connected to a direct-voltage source (U2) via a first and a second resistor (R3, R4) respectively, and whose electrodes, collectors or emitters, which are not connected to the direct-voltage source (U2) are connected to the collectors or emitters of a third and a fourth transistor (T3, T4) respectively, the bases of the third and the fourth transistors (T3, T4) also being interconnected and being connected to an electrode, the collector or the emitter, of the third or the fourth transistor (T3, T4) and the asymmetrical input signal being applied to the connection between the first and the third transistor (T1, T3) or to the connection between the second and the fourth transistor (T2, T4), characterized in that a third resistor (R1) is arranged in the connection between the first and the third transistor (T1, T3) and the collector-emitter path of a fifth transistor (T5) is arranged in the connection between the second and the fourth transistor (T2, T4), the base of said fifth transistor being connected to the junction point of the third resistor (R1) and the third transistor (T3).

2. A circuit arrangement as claimed in Claim 1, characterized in that a fourth resistor (R2) is arranged in the connection between the fourth and the fifth transistor (T4, T5) and in that all transistors (T1, T2, T3, T4, T5) are of the same conductivity type.

3. A circuit arrangement as claimed in Claim 2, characterized in that the asymmetrical input signal is applied to the base of the fifth transistor (T5) via a capacitance (C).

4. A circuit arrangement as claimed in Claim 2, characterized in that the asymmetrical input signal is applied to the junction point of the fourth resistor (R2) and the fourth transistor (T4) via a capacitance (C).

5. A circuit arrangement as claimed in Claim 4, characterized in that the junction point of the second and the fifth transistor (T2, T5) is connected to the bases of the third and the fourth transistor (T3, T4) via the collector-emitter path of a sixth transistor (T6), in that the base of the sixth transistor (T6) is connected to the junction point of the fourth resistor (R2) and the fourth transistor (T4), and in that all transistors (T1, T2, T3, T4, T5, T6) are of the same conductivity type.

6. A circuit arrangement as claimed in Claim 1, characterized in that the collector-emitter path of a sixth transistor (T7) is arranged between the third resistor (R1) and the third transistor (T3), which sixth transistor has its base connected to the base of the fifth transistor (T5) via a series arrangement of a fourth and a fifth resistor (R5, R6), the junction point of the third resistor (R1) and the sixth transistor (T7) is connected to the junction point of the fourth and the fifth resistor (R5, R6), those electrodes of the third and the fourth transistor (T3, T4) which are not connected to the fifth and the sixth transistor (T5, T7) are interconnected via a sixth resistor (R7), the bases of the third and the fourth transistor (T3, T4) are connected to the junction point of the fourth transistor (T4) and the sixth resistor (R7), the asymmetrical input signal is applied to the base of the fifth transistor (T5) via a capacitance (C), and the first, the second, the fifth and the sixth transistor (T1, T2, T5, T7) are of the same conductivity type and the third and the fourth transistor (T3, T4) are of the opposite conductivity type.


## Revendications

1. Circuit pour obtenir un signal et un signal symétrique à partir d'un signal d'entrée asymétrique présentant au moins un circuit à miroir de courant, muni d'un premier transistor et d'un deuxième transistor (T1, T2), dont les bases sont interconnectées et connectés à une source de tension continue réglable (U1), dont les collecteurs ou émetteurs sont connectés chaque fois par l'intermédiaire d'une première résistance et d'une deuxième résistance (R3, R4) à une source de tension continue (U2), et dont les électrodes, collecteurs ou émetteurs non connectés à la source de tension continue (U2) sont connectés aux collecteurs ou émetteurs d'un troisième transistor et d'un quatrième transistor (T3, T4), les bases des troisième et quatrième transistors (T3, T4) étant également interconnectées et connectées à une électrode, collecteur ou émetteur des troisième ou quatrième transistors (T3, T4) alors que le signal d'entrée asymétrique est introduit dans la connexion entre le premier transistor et le troisième transistor (T1, T3) ou dans la connexion entre le deuxième transistor et le quatrième transistor (T2, T4), caractérisé.en ce qu'une troisième résistance (R1) est insérée dans la connexion entre le premier transistor et le troisième transistor (T1, T3) et en ce que le trajet collecteur-émetteur d'un cinquième transistor (T5) est inséré dans la connexion entre le deuxième transistor et le quatrième transistor (T2, T4), la base de ce cinquième transistor (T5) étant connectée au point de connexion de la troisième résistance (R1) et du troisième transistor (T3).

2. Circuit selon la revendication 1, caractérisé en ce qu'une quatrième résistance (R2) est inséré dans la connexion entre le quatrième transistor et le cinquième transistor (T4, T5) et en ce que tous les transistors (T1, T2, T3, T4, T5) sont de même type de conductivité.

3. Circuit selon la revendication 2, caractérisé en ce que le signal d'entrée asymétrique est amené par l'intermédiaire d'un condensateur (C) à la base du cinquième transistor (T5).

4. Circuit selon la revendication 2, caractérisé en ce que le signal d'entrée asymétrique est amené par l'intermédiaire d'un condensateur (C) au point de connexion de la quatrième résistance (R2) et du quatrième transistor (T4).

5. Circuit selon la revendication 4, caractérisé en ce que le point de connexion du deuxième transistor et du cinquième transistor (T2, T5) est connecté par l'intermédiaire du trajet collecteur-émetteur d'un sixième transistor (T6) aux bases de troisième et quatrième transistors (T3, T4), en ce que la base du sixième transistor (T6) est connectée au point de connexion de la quatrième résistance (R2) et du quatrième transistor (T4) et en ce que tous les transistors (T1, T2, T3, T4, T5, T6) sont de même type de conductivité.

6. Circuit selon la revendication 1, caractérisé en ce qu'entre la troisième résistance (R1) et le troisième transistor (T3) est inséré le trajet collecteur-émetteur d'un sixième transistor (T7), dont la base est connectée par l'intermédiaire d'un montage en série d'une quatrième résistance et d'une cinquième résistance (R5, R6) à la base du cinquième transistor (T5), en ce que le point de connexion de la troisième résistance (R1) et du sixième transistor (T7) est connecté au point de connexion des quatrième et cinquième résistances (R5, R6), en ce que les électrodes non connectées aux cinquième et sixième transistors (T5, T7) des troisième et quatrième transistors (T3, T4), collecteurs ou émetteurs, sont connectées entre eux par l'intermédiaire d'une sixième résistance (R7), en ce que les bases des troisième et quatrième transistors (T3, T4) sont connectées au point de connexion du quatrième transistor (T4) et de la sixième résistance (R7), en ce que le signal d'entrée asymétrique est amené par l'intermédiaire d'une capacité (C) à la base du cinquième transistor (T5) et en ce que les premier, deuxième, cinquième et sixième transistors (T1, T2, T5, T7) sont d'un type de conductivité, alors que les troisième et quatrième transistors (T3, T4) sont du type de conductivité opposé.

Fig 1

Fig 2

Fig 3

Fig 4

Fig 5